Europäisches Patentamt

European Patent Office

Office européen des brevets

(11) Publication number: **0 406 786 A1**

# EUROPEAN PATENT APPLICATION

(21) Application number: 90112636.7

(22) Date of filing: 03.07.90

(51) Int. Cl.⁵: **H03K 3/037**, H03K 3/027, H03K 19/173, H03K 19/0175

(30) Priority: 04.07.89 IT 2108889

(43) Date of publication of application:
09.01.91 Bulletin 91/02

(84) Designated Contracting States:
AT BE CH DE DK ES FR GB GR IT LI LU NL SE

(71) Applicant: ALCATEL FACE STANDARD S.p.A.
Viale L. Bodio 33/39
I-20158 Milano(IT)

(72) Inventor: **Bellin, Michele**
Via Giotto Res. Spighe 621
I-20080 Basiglio, Milano(IT)

(74) Representative: **Brose, Gerhard et al**
Standard Elektrik Lorenz AG Patent- und
Lizenzwesen Postfach 30 09 29
D-7000 Stuttgart 30(DE)

(54) **Device for transforming a type "D" flip-flop into a flip-flop called type "B" able to sample data both on leading and trailing edges of the clock signal.**

(57) The present invention is directed to the technical field of discrete electronic components and in particular refers to a circuit device for transforming a type "D" flip-flop into a flip-flop called type "B" able to sample data both on leading and trailing edges of the clock signal, which has a first type "D" flip-flop at whose clock input is electrically connected an exclusive OR,to this first type "D" flip-flop is connected a second "D"-type flip-flop identical to the first one which,being also circuitally connected with the exclusive OR output, allows to realize a flip-flop called type "B" which represents,in the wholly integrated circuital form,a new discrete component which enables various circuital functions not possible or not practically feasible in the prior art.

Fig. 1.

## DEVICE FOR TRANSFORMING A TYPE "D" FLIP-FLOP INTO A FLIP-FLOP CALLED TYPE "B" ABLE TO SAMPLE DATA BOTH ON LEADING AND TRAILING EDGES OF THE CLOCK SIGNAL

The invention refers to a circuit device for transforming a type"D" flip-flop into a flip-flop called type "B" able to sample data both on leading and trailing edges of the clock signal and comprises an exclusive OR whose output is connected with the clock input of a type "D" flip-flop and delay circuit means also circuitally connected with the exclusive OR.

As it is known,in the field of circuital components,a problem arises since a type "D" flip- flop is not able to sample data at its input on both leading and trailing edges of the clock signal.

This limitation is,at present,overcome according to a first circuital configuration in which the clock input of a type "D" flip-flop is circuitally connected with the output of an exclusive OR,at one input of which is a delay element with which is possible to obtain a pulse of particular duration on the clock input of the type "D" flip-flop itself.

This delay element can be realized either by a delay line or by gates in cascade.In the first case,a rather short delay time is produced,in the second case a rather long delay time is produced.

Relatively to the short delay time,such value is usually known but the procedure for obtaining it involves a very high cost not comparable with the cost of the flip-flop itself.

For rather long delay times,it is not possible to calibrate such parameter a priori,except in a rather approximate manner,because in such case it depends on temperature and on parameters spread of the used logic components; besides,the theoretical delay time can change only in a discrete manner according to the number of gates used in the circuit.

However,the choice of delay time value is not a negligible factor in that the qualitative performances of the flip-flop are reflected in it from the viewpoint of both maximum toggle frequency and minimum pulse width.

More particularly,the correct choice of delay time value is important in that it depends on which considerations are made in order to calibrate the minimum duration of the signal to be sampled,besides in function of performances of the flip-flop to be used.For instance,if "D" indicates the minimum duration of the signal to be sampled,it is necessary to use a flip-flop with a maximum toggle frequency greater than 2/D.

From this it ensues that the ideal value of delay time is situated between the minimum pulse width and D/2, as hereinabove mentioned.

.For solving such problems it has been proposed to embody in a single circuit · a flip-flop identical to type "D" ˙flip-flop previously mentioned which,by means of a suitable delay line,allows to follow the same time variations as a function of supply voltage and temperature.

By exploiting such measures the object of the present invention is to eliminate the above mentioned drawbacks relatively to the prior art devices,by realizing and providing a circuital device for transforming a type "D" flip-flop into a type "B" flip-flop able to sample data at its input both on the leading and trailing edge of the clock signal,which allows to make the delay element for timing no longer critical but to adapt itself automatically to timing requirements of the used flip-flop.

This object and others yet,which will be more apparent from the following description,are achieved according to the present invention by means of a circuit device for transforming a type "D" flip-flop into a flip-flop called type "B" able to .sample data at its input both on leading and trailing edges of the clock signal,of the type comprising an exclusive OR,whose output is circuitally connected to the clock input of a first type "D" flip-flop, and a delay circuit means circuitally connected to the esclusive OR too,said device being characterized in that said delay means consists of a second type "D" flip-flop, whose outputs QN, Q are respectively the outputs QN,Q of the flip-flop called type "B",and whose input D is the input B of the flip-flop called type "B" and whose clock input is connected to the exclusive OR,this latter having two inputs the first one being the clock input of the flip-flop called type "B" and the second one being circuitally connected to the input D of said first flip-flop type "D" which input D,in turn,is short-circuited with the input QN of the same flip-flop.

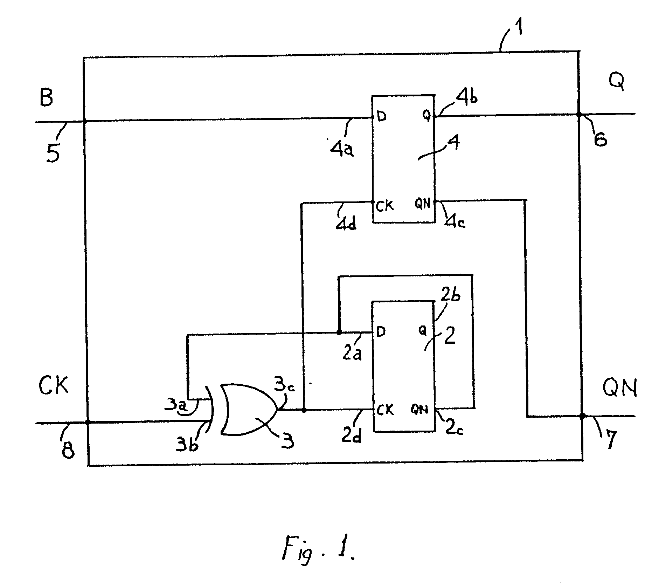

Further features and advantages of the invention will be more evident from the detailed description of a preferred but not exclusive embodiment of a circuital device for transforming a type "D" flip-flop into a flip-flop called type "B" able to sample data at its input both on leading and trailing edges of the clock signal,taken in the following with reference to the attached drawing,given as an indicative and therefore not limitative example,in which there is illustrated a block diagram where the circuital components of the device itself,according to the present invention,are outlined.

With reference to such figure,reference numeral 1 indicates as a whole the so-called type "B" flip-flop integrated in a single circuit arrangement.

Internally,we may distinguish a first type "D" flip-flop 2,connected with an exclusive OR 3 and with a second type "D" flip-flop,identical to the first one,indicated by reference numeral 4.

The type "B" flip-flip has an input B indicated by reference numeral 5,an output Q indicated by 6, a second output QN indicated by 7,as well as a clock input indicated by 8.

The B- input 5 of type "B" flip-flop is connected directly with input D of the second type "D" flip-flop indicated by 4a, whilst the output Q of the same type "D" flip-flop,indicated by 4b,is connected directly with the Q-output 6 of type "B" flip-flop.The clock input indicated by 4d of the flip-flop 4 is connected with the output 3c of exclusive OR 3,as well as with clock input of flip-flop 2 indicated by 2d.

The output 4c of flip-flop 4 is connected directly to the output QN indicated by 7 of type "B" flip-flop.

The clock input 8 of type "B" flip-flop 1 is directly connected to one 3b of the inputs of exclusive OR 3,while the other input 3a of the same exclusive OR 3 is circuitally connected to the input D,indicated by 2a,of flip-flop 2,which input is short-circuited with the output 2c of the flip-flop itself,which represents the output QN of flip-flop 2.The output 2b,namely output Q of flip- flop 2,is not circuitally connected,while the clock input as hereinbefore mentioned,is connected with the output 3c of exclusive OR 3 and is indicated in the diagram by reference 2d.

After a description given in a mainly structural meaning,the operation of the device according to the present invention is the following.

At each clock transition we have a switching of the flip-flop 4 which acts as a divider by two and hence provides,simultaneously,for the inversion of the clock input of flip- flop 2, namely on the input 2d,thus predisposing for the subsequent transition.

Since the propagation delay normally is greater or equal to the minimum pulse width,it is clear that this last,for both flip-flops,shows the feature for which the minimum clock width depends upon propagation time of flip-flop 2 to which the delay time due to exclusive OR 3 must be added.

In more details,propagation time of flip-flop 2 coincides with the smaller time unit which can be sampled and assigned to the delay element represented by flip-flop 4,whereas the propagation time of exclusive OR 3 assures an appropriate tolerance margin.

The time setting of two flip-flops is obtained taking into consideration that the sum of propagation times of flip-flop 2 and exclusive OR 3 must be less than half the minimum duration of the pulse to be sampled.

In summary,we come to the concept that,if we neglect the exclusive OR delay time,the smaller delay time t corresponds to propagation time of flip-flop 4.

Thus the invention full achieves the proposed objects.Indeed, in this way,it is possible to realize,in an intrinsic manner,a circuital arrangement which should require,otherwise,difficult parameters settings of the circuit itself.

Moreover,in this way there is provided a new discrete integrated component called type "B" flip-flop which,at present,is not available in the field of commercial electronic components and may be used,for instance,in the telecommunications field,as concerns the reread of data flow RZ by a clock which,through the use of a type "B" flip- flop,can work also at the same frequency of the flip-flop itself.

It is clear that the use of circuits and/or equivalent circuital components,even if structurally different,as well as technical-practical modifications,are not beyond the protective limits and the inventive sphere of the present invention,as hereinbefore described and herebelow claimed.

## Claims

1. A circuit device for transforming a type "D" flip-flop into a flip-flop called type "B" able to sample data at its input both on leading and trailing edges of the clock signal,of the type comprising an exclusive OR, whose output is circuitally connected to the clock input of a first type "D" flip-flop and a delay circuit means circuitally connected to the exclusive OR too,said device being characterized in that said delay means consists of a second type "D" flip-flop whose outputs QN,Q are respectively the outputs QN,Q of the flip-flop called type "B",and whose input D is the input B of the flip-flop called type "B", and whose clock input is connected to the exclusive OR,this latter having two inputs,the first one being the clock input of the flip-flop called type "B" and the second one being circuitally connected to the input D of said first type "D" flip-flop which input D,in turn, is short-circuited with the input QN of the same flip-flop.

2. A circuit device according to claim 1, characterized in that said device is embodied as a single discrete component integrated on a chip.

3. A circuit device for transforming a type "D" flip-flop into a flip-flop called type "B" able to sample data at its input both on leading and trailing edges of the clock signal as hereinbefore described and illustrated for the proposed objects.

Fig. 1.

EP 0 406 786 A1

| DOCUMENTS CONSIDERED TO BE RELEVANT | | EP 90112636.7 |

| Category | Citation of document with indication, where appropriate, of relevant passages | Relevant to claim | CLASSIFICATION OF THE APPLICATION (Int. Cl.5) |
|---|---|---|---|
| A | <u>GB - A - 2 123 634</u><br>(WESTERN ELECTRIC)<br>* Fig. 1; abstract *<br>-- | 1 | H 03 K 3/037<br>H 03 K 3/027<br>H 03 K 19/173<br>H 03 K 19/0175 |
| A | <u>US - A - 4 749 937</u><br>(SIMONS)<br>* Fig. 4 *<br>-- | 1 | |
| A | <u>EP - A2/A3 - 0 198 677</u><br>(ALTERA CORP.)<br>* Fig.4,10; abstract *<br>-- | 1 | |
| A | <u>EP - A2 - 0 310 377</u><br>(KAWASAKI)<br>* Fig. 4A,5A; abstract; claims *<br>---- | 1 | |
| | | | TECHNICAL FIELDS SEARCHED (Int. Cl.5)<br><br>H 03 K 3/00<br>H 03 K 19/00 |

The present search report has been drawn up for all claims

| Place of search | Date of completion of the search | Examiner |
|---|---|---|
| VIENNA | 15-10-1990 | BAUMANN |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P0401)